(19) **Europäisches Patentamt**
**European Patent Office**
**Office européen des brevets**

(11) **EP 1 326 097 B1**

(12) **EUROPEAN PATENT SPECIFICATION**

(45) Date of publication and mention
of the grant of the patent:
**03.01.2007 Bulletin 2007/01**

(51) Int Cl.:
*G02B 1/10* (2006.01)     *C23C 14/54* (2006.01)
*G01B 11/06* (2006.01)

(21) Application number: **02026463.6**

(22) Date of filing: **27.11.2002**

(54) **Process for forming a thin film and apparatus therefor**

Verfahren und Apparat für die Herstellung von dünnen Schichten

Procédé et appareil pour la formation de couches minces

(84) Designated Contracting States:
**AT BE BG CH CY CZ DE DK EE ES FI FR GB GR IE IT LI LU MC NL PT SE SK TR**

(30) Priority: **28.12.2001 JP 2001401267**

(43) Date of publication of application:
**09.07.2003 Bulletin 2003/28**

(73) Proprietor: **HOYA CORPORATION**
**Shinjuku-ku,**
**Tokyo 161-8525 (JP)**

(72) Inventors:
 • **Takahashi, Yukihiro,**
  **Hoya Corporation**
  **Tokyo 161-8525 (JP)**

 • **Mitsuishi, Takeshi,**
  **Hoya Corporation**
  **Tokyo 161-8525 (JP)**
 • **Shinde, Kenichi,**
  **Hoya Corporation**
  **Tokyo 161-8525 (JP)**

(74) Representative: **Kuhnen & Wacker**
**Patent- und Rechtsanwaltsbüro**
**Prinz-Ludwig-Strasse 40A**
**85354 Freising (DE)**

(56) References cited:
  **EP-A- 0 408 015**     **EP-A- 1 094 344**
  **US-A- 5 000 575**     **US-A- 5 425 964**

**Description**

Field of the Invention

The present invention relates to a process for forming a desired thin film on a surface of an article according to claim 1.

Prior Art

From US-A-5 425 964 a method is known with which a broadband spectral monitor and a generalised model of a film are used.

From US-A-5 000 575 a method is known for monitoring and controlling the deposition of an optical thin film having a refractive index gradient. The optical material to be deposited is evaporated at a controllable rate. With this known method a coevaporation process is realised, with which a material is evaporated having a lower index of refraction and is generally held at a predetermined rate while the evaporation of a material having a higher index of refraction is controlled. During the deposition, the film and a substrate are illuminated by a broadband light source. The incident light reflected by the film and substrate produces an interference pattern comprising a reflectance spectrum that is detected to compute an optical thickness estimate of the film. With this known method the detected reflectance is compared to a reflectance specified for that optical thickness by a predetermined refractive index profile of the desired film. The controllable rate of evaporation is then adjusted so that the reflective index of the material being deposited conforms to the predetermined profile.

From EP-A-1 094 344 a thin film forming method and apparatus is known according to which anti-reflection films are deposited on lenses that are held by a coating dome by vaporising an evaporation material with using an electron gun. The power to be applied to the electron gun is controlled so that a transmission or reflection light quantity value that is measured at each time point by an optical film thickness meter becomes equal or approximately equal to a standard light quantity value stored in a standard light quantity value data storing means.

From EP-A-0 408 015 a method of measuring the thickness of a film is known. Prior to measurement of the thickness of a thin film which is formed on a substrate, correlation data between the reflectance of the film for light and thickness thereof is stored in a data memory in the form of a table. A reference sample having a known reflectance is prepared and the energy of light reflected from the reference sample is measured. Also measured is the energy of light reflected from an objective sample having the thin film and the substrate. A value of the thickness is obtained through the table and by means of a calculation using the above-mentioned parameters.

In the process for forming a thin film on an article for forming a film, it is known that thin films having a uniform distribution of optical properties can be automatically produced in great amounts with excellent stability and reproducibility by controlling the amount of the film-forming material in flight in a manner such that a measured value depending uniquely on the optical film thickness which changes continuously during the process agrees with a reference value of the measurement. For example, in a process disclosed in Japanese Patent Application Laid-Open No. 2001-115260, utilising the phenomenon that, when an article having a thin film formed thereon is irradiated with prescribed light, the amount of light transmitted through or reflected from the thin film depends on the refractive index and the thickness of the thin film, an optical film thickness meter is used for measuring the amount of light reflected from or transmitted through the thin film and the amount of the film-forming material in flight is controlled in a manner such that the amount of transmitted light or reflected light obtained by the measurement by the optical film thickness meter continuously during the film formation is made close to or the same as a reference amount of light.

Problem to be Solved by the Invention

As described in paragraph numbers [0029] to [0031] of Japanese Patent Application Laid-Open No. 2001-115260, the reference amount of light may be obtained just by keeping the electric power supplied to an electric gun constant when various conditions of the apparatus are excellent. However, more frequently, various additional conditions must be controlled on the basis of experience and feeling of a skilled operator and the control is getting complicated.

For example, for commercial application of an antireflection film formed on a spectacle lens, it is necessary that not only the antireflection property but also the color of light reflected from the antireflection film be taken into consideration from the standpoint of fashion. Therefore, after the color is set at a wavelength selected by an engineer in charge of setting the interference color, the film is actually formed at the set wavelength and the color of the reflected light is confirmed by the naked eyes. When correction in the color of the reflected light is necessary, the wavelength set before, i.e., the filter set at the optical film thickness meter, is changed and the above operation is conducted again. This operation of forming the antireflection film is repeated until the desired color of the reflected light is obtained. In this case, it is necessary that the data of the reference amount of light be derived when the desired color of the reflected light is obtained. Thus, markedly complicated trial-and-error operations must be repeated.

Moreover, the types of the commercially provided antireflection films are numerous. Since the set wavelengths for these antireflection films are different from each other in many cases, the filters in the optical film thickness meters are frequently different from each other in the apparatuses in a production line. Therefore, when a specific antireflection film is formed in all apparatuses for forming a thin film in the production line, there is the possibility that complicated operations of actually measuring the data of the reference amount of light suited to the filter in each optical film thickness meter must be conducted.

The present invention has been made to overcome the above problems and has an object to provide a process for forming a thin film in which, when the wavelength designed for the thin film previously is changed, the data of the reference amount of light can be easily obtained even when the type of the filter in the optical film thickness meter is different among the apparatuses and to provide an apparatus therefor.

According to the present invention the above object is solved by the features of claim 1.

Improved embodiments of the inventive process for forming a desired thin film on a surface of an article result from the sub-claims.

The above object can be achieved by the following means:

A process for forming a desired thin film on a surface of an article by flying and depositing a film-forming material on said surface, comprising the steps of:

measuring a thickness of the thin film by an optical film thickness meter continuously during film formation and continuously controlling an amount of the film-forming material in flight during the film formation in a manner such that an amount of light measured by the optical film thickness meter and representing the measured film thickness is close to or the same as a reference amount of light set in advance, wherein

test formation of the desired thin film is conducted, a refractive index of the formed thin film is derived at a plurality of wavelengths by using the optical film thickness meter, a reference amount of light is obtained at a plurality of desired wavelengths from the obtained refractive indices by a theoretical calculation and the thin film having a desired optical thickness at a desired wavelenght is formed using an obtained reference amount of light, wherein

A: the optical film thickness meter is an optical thickness meter which utilises dependency of an amount of light of a prescribed wavelength transmitted throught or reflected by a thin film on at least a thickness and a refractive index of the thin film and, when an article for forming a film on which a thin film is formed is irradiated with prescribed light, provides a measuring result of the thickness of the thin film by measuring an amount of transmitted light or reflected light;

B: am amount of transmitted light or reflected light or a change in the amount of transmitted light or reflected light, which changes depending on a thickness of a thin film already formed on the surface of the article for forming a film, is measured by the optical film thickness meter continuously during the film formation; and

C: the reference amount of light is provided as collected data of the amount of light or the change in the amount of light obtained by the measurement by the optical film thickness meter continuously during formation of the desired thin film.

Brief Description of Drawings

Fig. 1 shows the construction of an apparatus for forming a thin film as an embodiment of the present invention;

Fig. 2 shows a diagram exhibiting the change in the amount of reflected light when a thin film is formed by vapor deposition on the surface of glass;

Fig. 3 shows a diagram exhibiting the range in the extension amount used for the control;

Fig. 4 shows a diagram exhibiting the inner structure of the optical film thickness meter.

Fig. 5 shows a diagram exhibiting the procedures for obtaining the curve describing dependency of the refractive index of the thin film on the wave length in the stage of designing the thin film;

Fig. 6 shows a table describing extension amounts at a plurality of wavelengths and the refractive indices corresponding to the extension amounts;

Fig. 7 shows a diagram exhibiting the refractive indices of the thin film at a plurality of wavelengths and a diagram exhibiting a curve expressed by the equation in which the constants Na, Nb and Nc are obtained by substituting the measured values into the equation; and

Fig. 8 shows a diagram exhibiting the change in the actual amount of light and a diagram exhibiting the change in the reference amount of light.

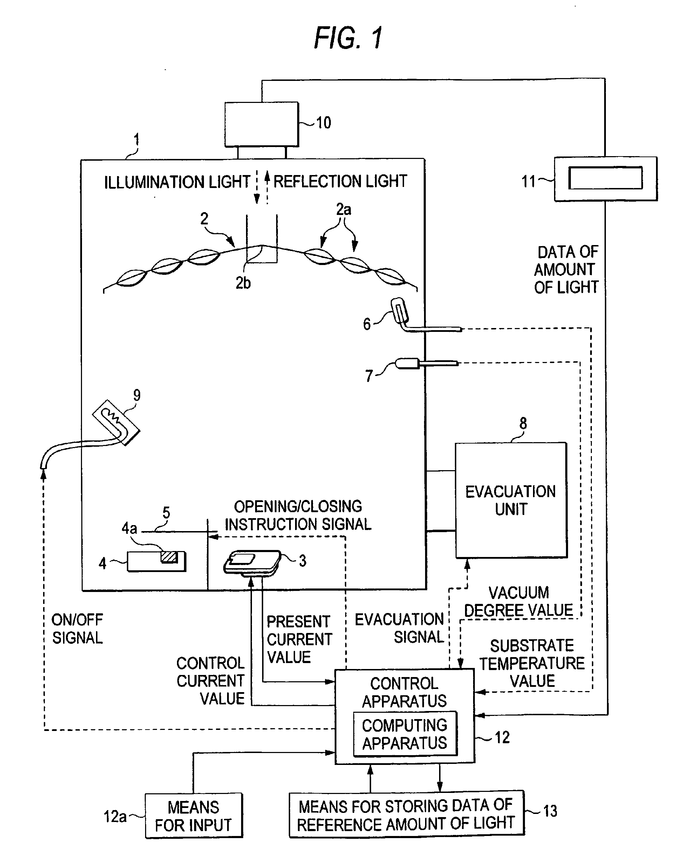

Fig. 1 shows the construction of an apparatus for forming a thin film as an embodiment of the present invention. This embodiment will be described with reference to Figure 1 in the following. The present embodiment relates to the formation of an antireflection film as the thin film on a spectacle lens made of a plastic as the article for forming a film.

In Fig. 1, in a vacuum chamber which is the chamber for the film formation, a coat dome 2 is disposed at an upper portion and an electron gun 3, a crucible 4 and a shutter 5 are disposed at lower portions. In the vicinity of the coat dome 2, a thermometer for substrates 6 for measuring the temperature of lenses 2a which are the articles for forming a film held by the coat dome 2 is disposed and a vacuum gauge 7 for measuring the degree of vacuum inside the vacuum chamber 1 and an evacuation unit 8 for evacuating the inside of the vacuum chamber 1 are also disposed. A halogen heater 9 is disposed for heating the lenses 2a held by the coat dome 2.

At an upper portion outside the vacuum chamber 1, an optical film thickness meter 10 is disposed. The optical film thickness meter 10 is connected to a control apparatus 12 via a film thickness monitor 11. To the control apparatus 12, a means for storing data of the reference amount of light 13 and a means for input 12a are connected. The electron gun 3, the shutter 5, the thermometer for a substrate 6, the vacuum gauge 7, the evacuation unit 8 and the halogen heater 9 are electrically connected to the control apparatus 12. The control apparatus 12 conducts various controls with exchange of information between these instruments.

The control apparatus 12 controls the evacuation unit 8 based on the information from the vacuum gauge 7 and keeps inside of the vacuum chamber 1 at a prescribed degree of vacuum. The control unit 12 keeps the lenses 2a which are the articles for forming a film at a prescribed temperature by controlling the halogen heater based on the information from the thermometer for substrates 6. The control unit 12 controls the electric power (the electric current and/or the voltage) applied to the electric gun 3 in a manner such that the amount of light which is continuously measured during the film formation by the optical film thickness meter 1 and depends on the optical thickness of the thin film formed on a monitor glass 2b is kept the same as the value stored in the means for storing data of a reference amount of light 13, each at the time of the measurement.

The coat dome 2 is a means for holding which holds the lenses 2a so that a thin film which is the antireflection film is formed on the lenses 2a which are the article for forming a film by vapor deposition. The coat dome 2 has a round concave shape so that a plurality of lenses can be coated by the vapor deposition and has a curvature so that all lenses are coated with the antireflection film with the same quality.

The electric gun 3 heats a substance for vapor deposition (a raw material) 4a placed in the crucible 4 at the melting point of the substance for vapor deposition (the raw material) 4a to vaporize the substance so that the substance for vapor deposition (the raw material) 4a is vapor deposited and accumulated on the lenses 2a and the monitor glass 2b to form thin films on these articles.

The crucible 4 is a conventional container used for holding the substance for vapor deposition 4a. It is preferable that the crucible is cooled or made of a substance having a great thermal conductivity so that bumping of the substance for vapor deposition is prevented when the substance for vapor deposition is heated by the electron gun 3.

The shutter 5 is opened when the vapor deposition is started and closed when the vapor deposition is completed. The shutter facilitates the control of the formation of the thin film. The halogen heater 9 is a means for heating which heats the lenses 2a at a suitable temperature so that the thin films formed by vapor deposition on the lenses 2a have suitable properties such as a suitable adhesive property.

The optical film thickness meter 10 utilizes the phenomenon that, when a transparent substrate having a transparent film formed thereon is irradiated with light, the light reflected at the surface of the transparent thin film and the light reflected at the surface of the transparent substrate interfere with each other due to the phase difference. The phase difference changes and, therefore, the condition of the interference changes depending on the refractive index and the optical thickness of the thin film. Thus, the entire amount of the reflected light changes depending on the refractive index and the optical thickness of the thin film. Since, naturally, the amount of the transmitted light also changes when the amount of the reflected light changes, the measurement may be conducted utilizing the transmitted light. However, the reflected light is used in the following descriptions of the measurement.

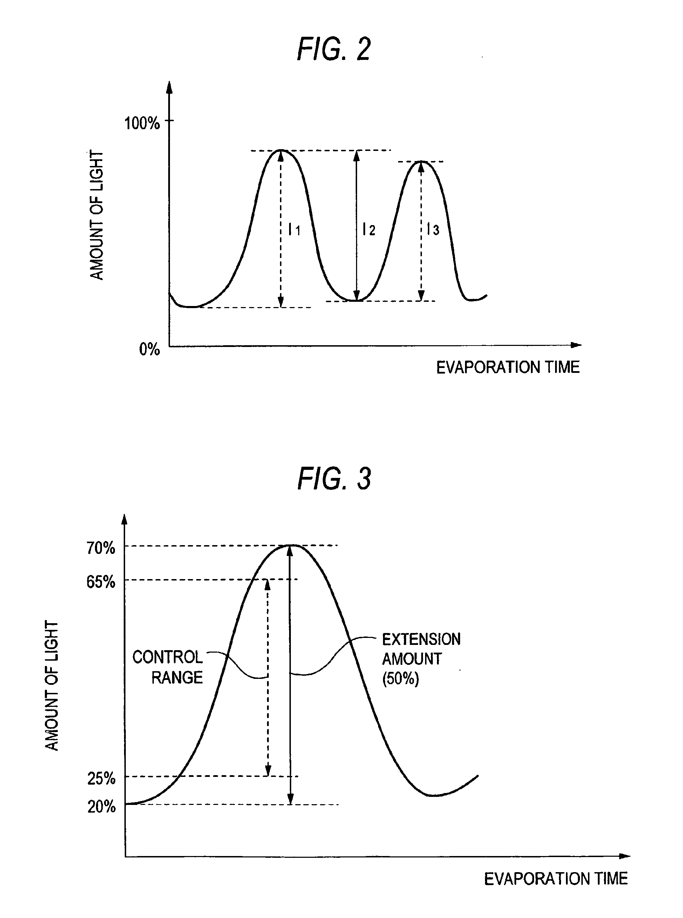

Fig. 2 shows a diagram exhibiting the change in the amount of reflected light when a thin film is formed by vapor deposition on the surface of the monitor glass. In the figure, the ordinate shows the amount of light (a relative value; the unit: %) and the abscissa shows the time of the vapor deposition. When the physical thickness of the thin film to be formed by the vapor deposition is great, the amount of light repeats an increase and a decrease regularly as the physical thickness increases when the refractive index of the thin film is constant. The thickness of the thin film can be uniquely measured and/or controlled by utilizing the refractive index of the thin film and the change in the amount of light which uniquely corresponds to the physical thickness of the thin film. In this case, the difference between the local maximum value and the local minimum value in each period will be referred to as the extension amount. In general, the extension amounts $1_1$, $1_2$, $1_3$ and so on are not always the same with each other.

The accuracy of the control decreases around the maximum and the minimum in the change in the amount of light. Therefore, in general, not the entire range but a portion of the extension amount is used for the control. Fig. 3 shows a diagram exhibiting the range in the extension amount used for the control. As shown in Figure 3, when the minimum of the amount of light is 20%, the maximum of the amount of light is 70% and the extension amount is 50%, for example, the areas of 5% at the top and the bottom are excluded and the area of the amount of light from 25 to 65% is used for the control.

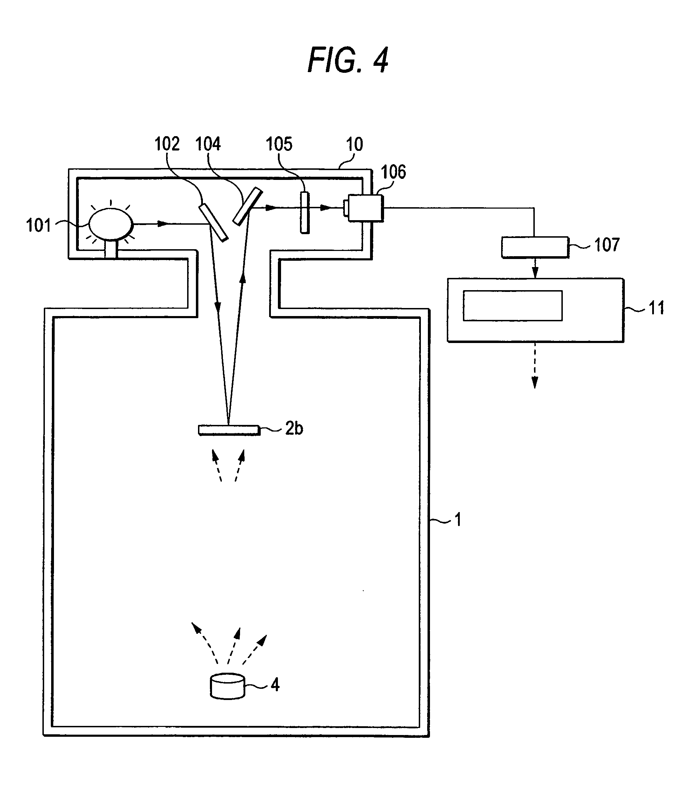

The structure of the optical film thickness meter will be described with reference to Figure 4 in the following. The optical film thickness meter is essentially constituted with a light-projecting lamp (101), a reflection mirror A (102), a monitor glass (2b), a reflection mirror B (103), a filter (105), a light-receiving sensor (106), a major portion of the thickness meter (11) and a pen recorder (107).

As the thickness of the thin film formed on the monitor glass (2b) changes, the amount of light reflected by the monitor glass (2b) changes and the amount of light changes. The light-projecting lamp (101) is the light source necessary for measuring the change in the amount of light. The light projected by the light-projecting lamp has a spectrum of intensity of radiation. To obtain the accurate amount of light, the spectrum of intensity of radiation can be analyzed by a spectrometer with respect to the wavelength. When the spectrum of intensity of radiation is continuous and does not show great changes with respect to the change in the wavelength, the amount of light measured by the optical film thickness meter means a relative intensity of light, as described later. Therefore, in this case, the amount of light can be measured by the optical film thickness meter without analyzing the spectrum of intensity of radiation with respect to the wavelength.

The reflection mirror (102) is used essentially for reflecting the incident light projected by the light-projecting lamp (101) and leading the reflected light to the monitor glass (2b). The degree of reflection of the reflection mirror (102) is not particularly limited. When the easiness in the calculation of the amount of light is considered, it is preferable that the entire amount of the incident light projected from the light-projecting lamp (101) is reflected.

The monitor glass is disposed at a position such that the substance of vapor deposition is vapor deposited and a film is formed on the lower surface of the monitor glass. When the film of the substance of vapor deposition is formed on the lower surface of the monitor glass, the amount of the light which has come from the reflection mirror A (102) and is reflected by the monitor glass changes with the change in the thickness of the formed thin film. The amount of light is obtained by utilizing the change in the amount of the reflected light. It is preferable that the monitor glass has a thickness such that the possibility of the interference can be excluded. The material of the monitor glass is not particularly limited. Glass materials having known refractive indices are preferable and glass materials comprising silicon dioxide are more preferable.

The refractive index of the monitor glass can be obtained by the measurement using a spectrometer. It is preferable that this measurement is conducted in a vacuum since the monitor glass is, in general, disposed inside the vapor deposition apparatus in a vacuum. However, since the difference in the refractive indices of the monitor glass measured in a vacuum and in the atmosphere does not significantly affect the value of the amount of light obtained by the measurement, it is possible that the refractive index of the monitor glass is measured in the atmosphere.

The reflection mirror B (104) is disposed for further leading the light reflected by the monitor glass (2b) to the light-receiving sensor (106). It is preferable that the reflection mirror reflects the entire amount of the incident light similarly to the reflection mirror A (102).

The filter (105) is used for selectively transmitting light having a prescribed range of wavelength in the incident light coming from the reflection mirror B (104). In general, a desired filter can be selected among various filters. In a plant producing many types of antireflection films in a great amount, many vapor deposition apparatuses are installed and a filter suited for the wavelength designed for the antireflection film to be formed is attached as the filter (105) to each vapor deposition apparatus. Therefore, the filters attached to the vapor deposition apparatuses are frequently not the same with each other in a plant producing many types of antireflection films in a great amount.

The filter (105) has a characteristic transmission spectrum. In other words, the manner of transmitting light having a specific range of wavelength is the characteristic of the filter. The spectrum of the transmitted light can be obtained by using a spectrometer and the value of the spectrum obtained by using the spectrometer is used for calculation of the reference amount of light. However, to facilitate the calculation, the value of the spectrum may be replaced with a normal distribution function described in the following:

[Mathematical equation 1]

$$T_{filter}(\lambda) = \frac{1}{\sqrt{2\pi \det \lambda}} \exp^{-\frac{(\lambda-\lambda 0)^2}{2\det \lambda^2}}$$

wherein

$\lambda$: a dispersed wavelength (nm)

$\lambda_0$: the central wavelength (nm)

$\lambda$: a wavelength

$T_{filter}(\lambda)$: the transmission of light of $\lambda$ through the filter

As the light-receiving sensor (106), a sensor which can accurately detects the light transmitted through the filter (105) is preferable. The intensity of the light reaching the light-receiving sensor (106) can be found from the sum of the intensities of light passed through the filter (105) with respect to each wavelength in the spectrum.

The main portion of the thickness meter (11) converts the intensity of light detected by the light-receiving sensor (106) into a relative number (expressed as a percentage). For example, light is projected from the light-projecting lamp (101) to the reflection mirror A (102) when no thin film is formed on the monitor glass (2b) and the amount of light detected by the light-receiving sensor in this condition is set at a desired number such as 20% and 30% as the initial value of the amount of light. Using the initial value as the reference, the local maximum and the local minimum in a period of change in the amount of light observed during the formation of the thin film are obtained. When the initial value is used as the reference as described above, the amount of light is expressed as a relative value. The range of the wavelength for the measurement is restricted by the filter described above. Therefore, practical data of the reference amount of light can be obtained without measuring the spectrum of radiation intensity of the light-projecting lamp (101).

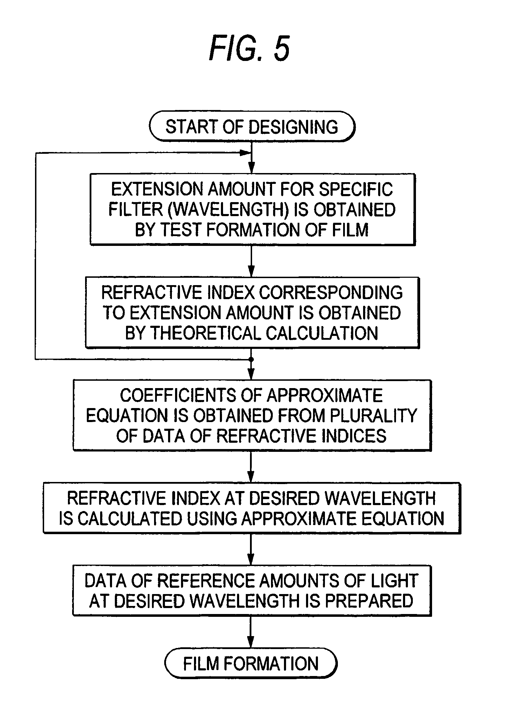

In the present embodiment, the reference amount of light is obtained by conducting the test vapor deposition in the stage of designing the thin film. The curve describing the dependency of the refractive index of the thin film on the wavelength is obtained and the reference amount of light is theoretically calculated using the obtained refractive index. The procedures will be described in more detail in the following. Fig. 5 shows a diagram exhibiting the procedures for obtaining the curve describing the dependency of the refractive index of the thin film on the wavelength in the stage of designing the thin film and the procedures for forming the thin film. The curve describing the dependency of the refractive index of the thin film on the wavelength is obtained in accordance with the procedures shown in Fig. 5.

(1) Start of designing

The optical design of the thin film to be obtained by the film formation is conducted. For example, it is assumed that the thin film to be obtained by the film formation is an antireflection film formed on the surface of a spectacle lens. The antireflection film is, for example, an antireflection film having a simple structure in which films having a high refractive index and films having a low refractive index are laminated alternately. For the design of the film, the refractive indices, the thickness and the number of films are decided in accordance with the range of wavelength of the light to prevent reflection thereof, the antireflection property, the color of the reflected light and the like other factors.

(2) Test vapor deposition

The above designing is conducted for the antireflection film which is to be formed on the surface of the spectacle lens. However, the film formation is controlled not directly by using the antireflection film formed on the spectacle lens itself but indirectly by using a thin film formed on the monitor glass. The reason for this procedure is that smoothness and accuracy of the surface of the monitor glass can be kept constant since the monitor glass is made of an inorganic material while smoothness and accuracy of the surface of the spectacle lenses are different among the spectacle lenses since most of the spectacle lenses are made of an organic material and that the observation by an optical film thickness meter is easier for the monitor glass since the monitor glass has a flat surface while the observation of a spectacle glass by an optical film thickness meter has difficulty since the spectacle lens has a curved surface. The test vapor deposition is conducted for the above purpose based on the values decided by the design.

In the test vapor deposition, the test film formation is conducted on the surfaces of a spectacle lens and the monitor glass. Thin films are formed on the spectacle glass and the monitor glass simultaneously under a condition such that the thin film formed on the spectacle lens is provided with the values decided by the design after the spectacle lens having the thin film is taken out into the atmosphere and the amount of light from the monitor glass during the film formation is measured by an optical film thickness meter. The measurement is conducted using a filter for a specific wavelength in the optical film thickness meter and the amount of light having the specific wavelength is measured. Further, a plurality of test vapor deposition are conducted using filters transmitting light having different wavelengths and the amount of light is obtained for each filter.

(3) Deriving the refractive index of the thin film at each wavelength

The amount of light measured by the optical film thickness meter can be theoretically calculated when constants of apparatuses such as the light source, the reflection mirrors, the filters and the light-receiving sensor and factors characteristic in the film formation such as the reflectivity at the surface of the monitor glass are known. When the actual conditions of the film formation and the actually used optical film thickness meter are considered, the constants of the apparatuses can be obtained relatively easily. In many cases, the factors characteristic in the film formation such as the refractive index of the monitor glass itself are known. Therefore, the amount of light measured by the optical film thickness meter can be theoretically calculated relatively easily. The factor which remains unknown in the theoretical calculation is the refractive index of the film formed on the surface of the monitor glass. When the factors other than the refractive index of the formed film are known, the remaining factor, i.e., the refractive index of the thin film at various wavelengths, can be obtained by deriving the amount of light for each filter described above by the measurement.

As for the theory for the calculation of the refractive index of the thin film at the wavelengths described above, the optical thickness of the thin film when the reflectivity shows the local maximum and the local minimum in the film formation on the monitor glass can be obtained by theoretical calculation. When the local maximum amount of light and the local minimum amount of light are known, the extension amount described above can be obtained. Since a filter is used for the optical film thickness meter, the local maximum amount of light and the local minimum amount of light are the values at the wavelength transmitted through the used filter. When the optical thickness of the thin film providing the monitor glass with the local maximum of the reflectivity is known, the refractive index of the thin film at the wavelength of light transmitted through the filter can be obtained. The above descriptions will be further described with reference to simplified equations in the following.

When the following factors are represented as follows:

the reflectivity of the monitor glass having the thin film: (r)
the optical thickness of the thin film: L
the physical thickness of the thin film: d
the refractive index of the thin film: n

the relations between these factors are expressed by the following simplified equations:

$$\Delta = \Delta(n, d) \quad \cdots (i)$$

$$L = L(n, d) \quad \cdots (ii)$$

wherein $\Delta$ represents the difference in the reflectivity.

When the optical thickness (L) of the thin film at the local maximum amount of light described above and the difference in the reflectivity $\Delta$) corresponding to the optical thickness are substituted into above equations (i) and (ii), the refractive index of the thin film n can be obtained. When the refractive index and the optical thickness of the thin film are substituted into equation (ii), the physical thickness of the thin film can be obtained.

Next, it will be described in the following that the reflectivity, the refractive index of the thin film and the amount of light have a relation among each other. The amount of light $Q(t)$ (%) detected at a time t by the light-receiving sensor 106 of the optical film thickness meter can be expressed by the following equation:

[Mathematical equation 2]

$$Q(t) = \left\{ \frac{\sum_{\lambda=380}^{780} P(\lambda,t)}{\sum_{\lambda=380}^{780} P(\lambda,0)} \right\} \cdot Q_0 \qquad \cdots (1)$$

In the above equation, it is assumed that the following conditions are satisfied:

(a) Q0 represents the initially set amount of light.
(b) $P(\lambda,t) = $ Rmonitor(d1, d2, $\cdots$, dk(t), n0($\lambda$), n1($\lambda$), n2($\lambda$), ..., nk($\lambda$)).

$$T(\lambda) \cdot X(\lambda) \qquad \ldots (2)$$

(c) P represents the absolute amount of light.
(d) $T(\lambda)$ represents the transmittance through the filter 105, $X(\lambda)$ represents functions depending on the optical members constituting the film thickness meter such as the intensity function ($S(\lambda)$) of the light-projecting lamp 101 and the reflectivities (Rmirror($\lambda$)) of the reflection mirrors 102 and 104. In general, these factors can be used as constants of apparatuses.
(e) R represents the reflectivity of the monitor glass and can be obtained by a well known optical calculation such as the calculation using the following equation (3). The factors are the refractive index of the glass n0($\lambda$), the thicknesses of layers d1, d2, $\cdots$, d(t) and the refractive indices of layers n1($\lambda$), n2($\lambda$), $\cdots$, n($\lambda$) when the entire film is composed of k layers. d alone is a function of t.

$$\text{Rmonitor}(\lambda) = \{R1(\lambda)\,(1-R2(\lambda))+R2(\lambda)\,(1-R1(\lambda))\} \,/$$

$$\{1-R1(\lambda)\cdot R2(\lambda)\} \qquad \cdots (3)$$

(f) In the above equation (3), $R1(\lambda)$ represents the reflectivity at the surface (the upper surface) of the monitor glass and $R2(\lambda)$ represents the reflectivity at the back surface (the lower surface) of the monitor glass.

The reflectivity $R1(\lambda)$ at the surface (the upper surface) of the monitor glass can be obtained when the refractive index of the monitor glass is known. In contrast, the reflectivity $R2(\lambda)$ at the back surface (the lower surface) of the monitor glass depends on the thin film formed on the back surface of the monitor glass. When the thin film formed on the back surface of the monitor glass is a multi-layer film constituted with a plurality of layers, the relations can be expressed as described in the following.

When each layer in the multi-layer film is a uniform film or can be divided into uniform films, each layer can be expressed by the following four-element matrix having two rows and two columns:

[Mathematical equation 3]

$$M = \begin{pmatrix} \cos g & iu^{-1}\sin g \\ iu\sin g & \cos g \end{pmatrix} \qquad \ldots (4)$$

wherein $g=(2\pi/\lambda)\cdot n(\lambda)\cdot d(t)\cdot\cos \Phi$
$u= n(\lambda) \cos \Phi$ (s-polarized)
$n(\lambda) \sec \Phi$ (p-polarized)
$\lambda$: the wavelength of light
$n(\lambda)$: the refractive index of the film at a wavelength $\lambda$

d(t): the thickness of the film at a time expressed by second

$\Phi$: the incident angle of light into the film

The multi-layer film having k layers which is formed on the surface of the monitor glass is expressed by the product of characteristic matrices (four-element matrices) for each layer. The characteristic matrix M is expressed by the following equation (5):

[Mathematical equation 4]

$$\mathbf{M} = \begin{pmatrix} m_{11} & im_{12} \\ im_{21} & m_{22} \end{pmatrix}$$

$$= \prod_{j=1}^{k} Mj \qquad \cdots (5)$$

From the characteristic matrix M, the amplitude reflectivity $r(\lambda)$ of the multi-layer film can be expressed as:

[Mathematics equation 5]

$$r(\lambda) = \frac{(m_{11} + im_{12}u_s)u_0 - (im_{21} + m_{22}u_s)}{(m_{11} + im_{12}u_s)u_0 + (im_{21} + m_{22}u_s)} \qquad \cdots (6)$$

wherein $u_0 = n_0 \cos \Phi_0$ (s-polarized)

$n_0 \sec \Phi_0$ (p-polarized)

$u_S = n_S \cos \Phi_S$ (s-polarized)

$n_S \sec \Phi_S$ (p-polarized)

$n_0$: the refractive index of a medium (vacuum)

$\Phi_0$: the incident angle of light into the film

$n_S$: the refractive index of the monitor glass

$\Phi_S$: the incident angle of light into the next film

The energy reflectivity $R1(\lambda)$ is expressed as:

$$R1(\lambda) = |r(\lambda)|^2 \qquad \cdots (7)$$

As clearly shown by equations (1) to (7), the amount of light Q(t) measured by the optical film thickness meter is a function of the refractive index of the monitor glass $R(\lambda)$ and the refractive index of the thin film $n(\lambda)$. $T(\lambda)$, $X(\lambda)$, d (t), the refractive index of the monitor glass n, the incident angle into the film $\Phi$ and the wavelength $\lambda$ can be obtained as constants.

(4) Deriving an approximate curve exhibiting the relation between the refractive index of the thin film and the wavelength

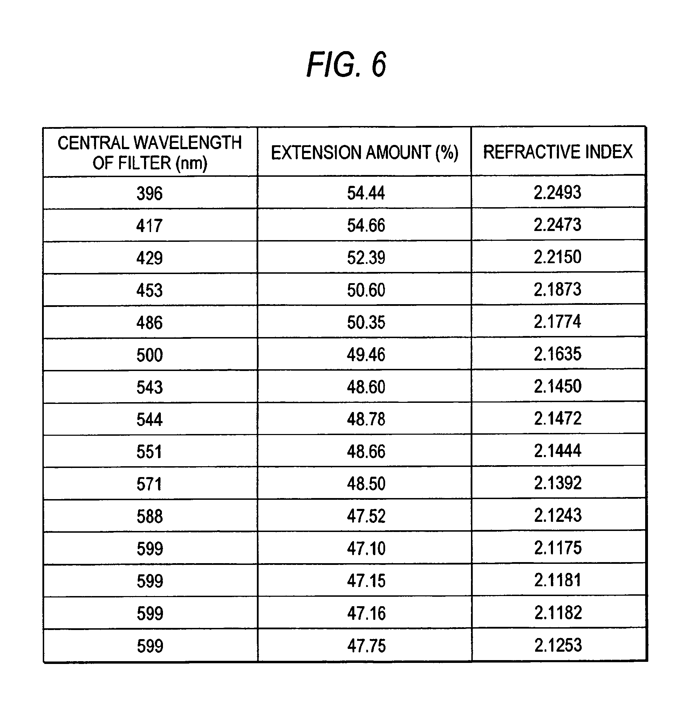

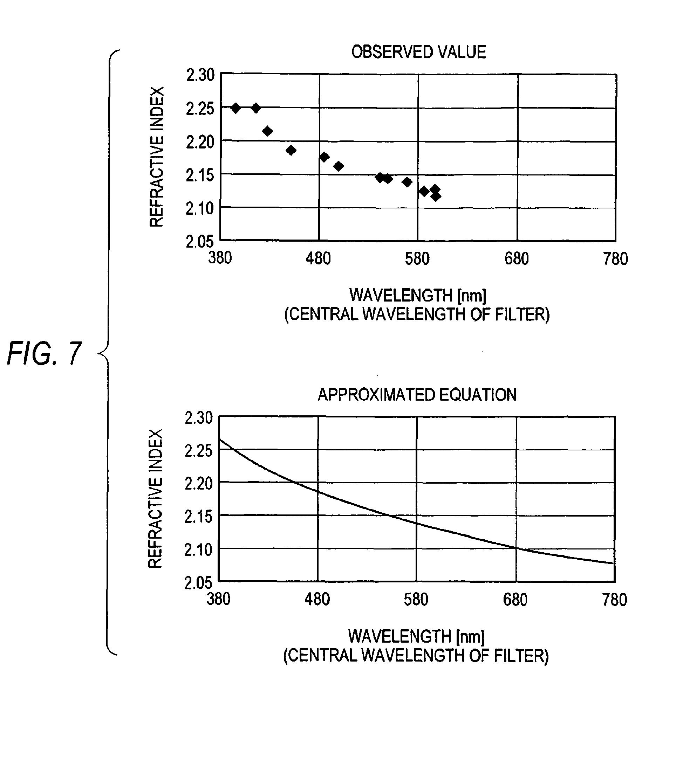

Fig. 6 shows a table exhibiting the extension amounts at a plurality of wavelengths obtained in step (3) described above and the refractive indices corresponding to the extension amounts. As shown in Fig. 6, when the refractive indices of the thin film at a plurality of wavelengths are obtained, the characteristic curve approximately exhibiting the dependency of the refractive index of the thin film on the wavelength can be obtained. In other words, when the refractive index of the thin film at the wavelength $\lambda$ is represented by $N(\lambda)$, the characteristic curve can be approximately expressed as $N(\lambda) = Na + Nb/(\lambda + Nc)$, wherein Na, Nb and Nc represent refractive index coefficients characteristic for the substance. Fig. 7 shows a diagram exhibiting the measured refractive indices of the thin film at a plurality of wavelengths and a diagram exhibiting a curve expressed by the above equation in which the constants Na, Nb and Nc are obtained by substituting the measured values into the above equation.

(5) Calculation of the refractive index of the thin film at a desired wavelength

Using the equation describing the characteristic curve approximately exhibiting the dependency of the refractive index of the thin film on the wavelength obtained in (4), the refractive index at a desired wavelength is calculated.

(6) Preparation of data of the reference amount of light of the thin film at the desired wavelength

When the refractive index and the physical thickness of the thin film to be formed at the desired wavelength are known, the reflectivity at the monitor glass as measured by the optical film thickness meter can be obtained. Therefore, the amount of light can be obtained continuously during the film formation. The change in the reference amount of light can be obtained by differentiating the obtained reference amount of light. The reference amount of light thus obtained is stored as the amount of light 1 (%) of the optical film thickness meter at a time t (second) in the means for storing the data of the reference amount of light in the form of the data of the amount of light having a pair of the time and the amount of light.

In the actual production, when the color of the reflected light (the interference color) of a thin film formed based on the reference amount of light or the change in the reference amount of light obtained by the theoretical calculation is examined, the obtained color is occasionally somewhat different from the desired color of the reflected light (the interference color). In this case, the wavelength set for the calculation is modified to some degree and the refractive index of the thin film at the modified wavelength is obtained from the characteristic curve exhibiting the dependency of the refractive index of the thin film on the wavelength. Using the refractive index of the thin film at the modified wavelength, the reference amount of light or the change in the reference amount of light is obtained by the theoretical calculation. By forming the film based on the reference amount of light or the change in the reference amount of light obtained above, the thin film having the color of the reflected light (the interference color) desired for the production can be produced relatively easily with stability.

When it is found during the setting of the color (the interference color) that the selection of the filter 105 in the optical film thickness meter 10 is not suitable, the data of the reference amount of light for the filter which replaces the current filter can be easily prepared by the above theoretical calculation. When the number of the type of the antireflection film is great in the actual production line, the type of the filter in the optical film thickness meter may be different among the vapor deposition apparatuses. In this case, the refractive index of the thin film at the wavelength of light transmitted by the filter currently used is obtained from the characteristic curve exhibiting the dependency of the refractive index of the thin film on the wavelength and the modified reference amount of light or the modified change in the reference amount of light is obtained by the theoretical calculation. The film formation can be conducted using the modified reference amount of light or the modified change in the reference amount of light thus obtained. Therefore, when the filter of the optical film thickness meter is replaced with another filter, the reference amount of light or the change in the reference amount of light is easily decided and the film formation can be conducted with stability using the reference amount of light or the change in the reference amount of light thus decided.

In the above description, a method of selecting the filter 105 transmitting the reflected light is used as the example of the method for selecting the wavelength used in the optical film thickness meter. As another method, where desired, a filter transmitting light projected from the light-projecting lamp is used and the thin film is irradiated with the light transmitted through the filter. The wavelength may be changed by changing this filter. As still another method, a lamp projecting a prescribed specific light may be used as the light-projecting lamp and a plurality of such lamps which project light of different wavelengths may be used. The wavelength may be changed by changing the light-projecting lamp. In the method described above, as the method for obtaining the reference amount of light, a plurality of the refractive indices are obtained by the test formation of films, the equation describing the relation between the wavelength and the refractive index is obtained based on the plurality of the refractive indices thus obtained, the refractive index at a desired wavelength is obtained using the obtained equation and the data of the reference amount of light at the desired wavelength is obtained by substituting the thus obtained refractive index into the equation expressing the amount of light theoretically. However, the data of the reference amount of light at the wavelength used in the test formation of the film are already obtained in the test formation of the film. In other words, at a plurality of wavelengths, the data of the reference amount of light themselves are already obtained in the test formation of the film. Therefore, using the data of the reference amount of light at these wavelengths, the data of the reference amount of light not obtained as above can be derived in accordance with the interpolation method or the like other method. As still another method, for example, when the data of the reference amount of light obtained by the test formation of the film arc shown as curves in a graph, the curve of the reference amount of light at another wavelength may be placed between the plurality of the obtained curves. The curve of the reference amount of light at a desired wavelength may be obtained by obtaining the curve from the other known curves in accordance with the interpolation method or the like other method.

(7) Process for forming the thin film

The process for forming the thin film of the present embodiment will be described specifically in the following. The control by the optical film thickness meter using the reference amount of light or the change in the reference amount of light has been known as described in Japanese Patent Application Laid-Open Nos. 2001-115260 and 2001-123269 and European Patent Application Laid-Open No. 1094344. In the coat dome 2, the lenses 2a as the articles for forming a film and the monitor glass 2b are set and the material of vapor deposition 4a is placed into the crucible 4. Then, the vacuum chamber 1 is evacuated to a prescribed degree of vacuum and the lenses 2a are heated at a prescribed temperature by the halogen heater 9. Thereafter, the control of electric power applied to the electron gun 3 is started so that the vapor deposition can be started.

The formation of the film by the vapor deposition starts when the shutter 5 is opened. Therefore, the time is set at 0 when the shutter 5 is opened and the time passed thereafter is expressed by t (second). In general, when the shutter 5 is opened, the amount of light in the optical film thickness meter 10 begins to change. However, actually, the beginning of the change in the amount of light is occasionally delayed. In this case, a prescribed electric power may be forced to be applied to the electron gun 3 after a prescribed time has passed so that the control can be started.

The film formation is conducted under the software control by the computer. The reference amount of light stored in the means for storing the reference amount of light 13 is read out, compared with the amount of light actually obtained by the measurement and the electric current of the electron gun is adjusted so that these amounts of light agree with each other. The control of the electric current of the electron gun is conducted, for example, in the following manner. When the amount of light (the value obtained by the measurement = the actual amount of light) at a time (the actual time) $t_{i-1}$ from the time when the shutter is opened is expressed by $I_{i-1}$, the reference amount of light $I_S$ which is the same as $I_{i-1}$ ($I_S=I_{i-1}$) is retrieved from the reference data (i means that this operation is the i-th control). When the value which is the same as $I_{i-1}$ is not found, an approximate value is calculated. Then, the time $t_S$ (the reference time) corresponding to this amount of light $I_S$ is calculated from the reference data.

The amount of light (the value obtained by the measurement = the actual amount of light) corresponding to the time $t_i$ which is the time after the actual time $t_{i-1}$ by a control interval $\Delta t$ (second) is expressed by $I_i$. Separately, the reference amount of light $I_{S'}$ corresponding to the reference time $t_{S'}$ (=$t_S+\Delta t$) is obtained from the reference data.

$\Delta I_i$ and $\Delta I_{Si}$ are defined as follows:

$$\Delta I_i \equiv I_i \text{-} I_{i-1}$$

$$\Delta I_{Si} \equiv I_{S'} \text{-} I_S$$

and $R_i$ is defined as follows:

$$R_i \equiv I \text{-} \Delta I_i / \Delta I_{Si}$$

or

$$R_i \equiv (I_{S'} - I_i)/(I_{S'} - I_S)$$

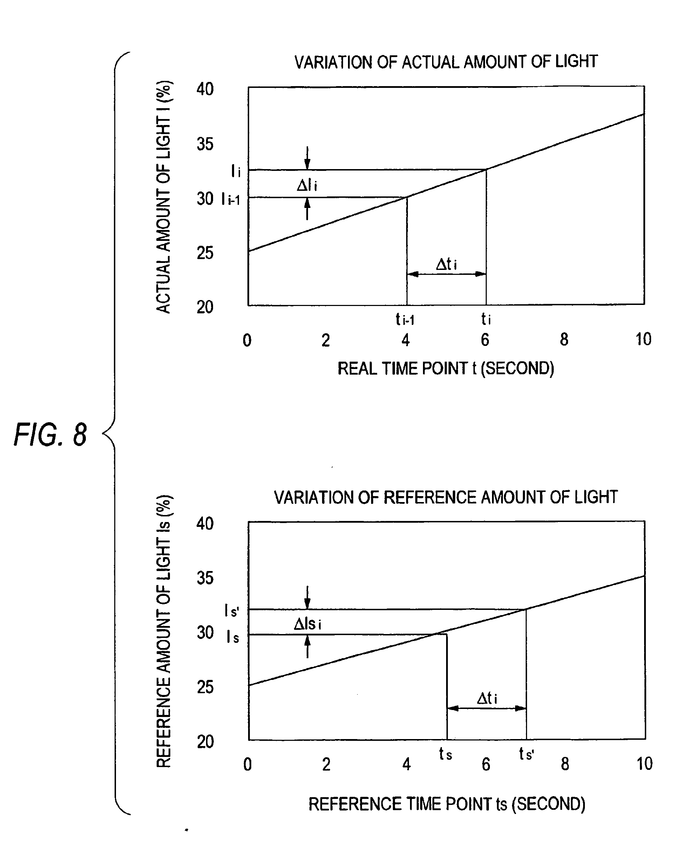

Fig. 8 shows a diagram exhibiting the change in the actual amount of light and a diagram exhibiting the change in the reference amount of light.

$R_i$ is further converted as follows:

$$Q_i \equiv k R_i |R_i|$$

wherein k represents an arbitrary constant. Using $Q_i$ shown above, the PID control (the control of proportion, integration and differentiation) is conducted and the power of the electron gun $P_i$ is decided at a desired time. The equation for the PID control deciding the value of the power of the electron gun $P_i$ is shown in the following:

$$P_i \equiv P_{i-1} + Kp \cdot Q_i + Ki \cdot \Sigma Q_i + Kd \cdot det \ Q_i$$

wherein Kp, Ki and Kd each represent an arbitrary constant.

$\Sigma Q_i$ is expressed as follows:

[Mathematical equation 6]

$$\sum Qi \equiv \int_{i-1}^{i} Q(t)dt$$

$$det \ Q_i \equiv Q_i - Q_{i-1}$$

The above control is conducted at intervals of the control interval $\Delta t_i$ (second).

The control interval $\Delta t$ (second) is changed in accordance with the degree of agreement (R). In general, when the degree of agreement is greater (the value of R is closer to 0), the control interval $\Delta t$ is set at a greater value. It is also possible that the PID control (the control of proportion, integration and differentiation) is conducted using R and the power of electron gun $P_i$ is decided at a desired time.

Effect of the invention

As described in detail in the above, in the present invention, the desired film formation is conducted while the amount of light of the thin film is continuously measured by the optical film thickness meter during the film formation and the conditions of the film formation are controlled in a manner such that the amount of light obtained by the measurement agrees with the reference amount of light. The reference amount of light in the above procedure is obtained as follows: the refractive index is obtained at a plurality of wavelength by the theoretical calculation using the amount of light obtained by the actual measurement in the test formation of a film in the designing stage; the relation between the wavelength and the refractive index with the formed film is obtained from the plurality of refractive indices; the refractive index for the film formation at the desired wavelength is obtained; and the reference amount of light is obtained by substituting the obtained refractive index into the above theoretical equation. In accordance with the above process, the thin film having the prescribed properties at the desired wavelength can be easily formed.

Description of the reference numbers

**[0071]**

1:      A vacuum chamber
2:      A coat dome
3:      An electron gun
4:      A crucible
5:      A shutter
6:      A thermometer for a substrate
7:      A vacuum gauge
8:      An evacuation unit
9:      A halogen heater
10:     An optical film thickness meter
11:     A film thickness monitor
12:     A means for control
13:     A means for storing data of reference amounts of light

**Claims**

1. A process for forming a desired thin film on a surface of an article by flying and depositing a film-forming material on said surface, comprising the steps of: measuring a thickness of the thin film by an optical film thickness meter continuously during film formation and continuously controlling an amount of the film-forming material in flight during the film formation in a manner such that an amount of light measured by the optical film thickness meter and representing the measured film thickness is close to or the same as a reference amount of light derived in advance by means of a test formation of the thin film, wherein

   when said test formation of the desired thin film is conducted, a refractive index of the formed thin film is derived at a plurality of wavelengths, respectively, by using the optical film thickness meter, a reference amount of light is derived at a plurality of desired wavelengths from the obtained refractive indices by a theoretical calculation and the thin film having a desired optical thickness at a desired wavelength is formed using an obtained reference amount of light, wherein

   A: the optical film thickness meter is an optical thickness meter which utilizes dependency of an amount of light of a prescribed wavelength transmitted through or reflected by a thin film on at least a thickness and a refractive index of the thin film and, when an article for forming a film on which a thin film is formed is irradiated with prescribed light, provides a measuring result of the thickness of the thin film by measuring an amount of transmitted light or reflected light;

   B: an amount of transmitted light or reflected light or a change in the amount of transmitted light or reflected light, which changes depending on a thickness of a thin film already formed on the surface of the article for forming a film, is measured by the optical film thickness meter continuously during the film formation; and

   C: the reference amount of light is provided as collected data of the amount of light or the change in the amount of light obtained by the measurement by the optical film thickness meter continuously during formation of the desired thin film.

2. A process according to claim 1, wherein the reference amount of light is obtained in accordance with a process comprising the steps of:

   a. conducting the test formation of the thin film while the amount of light or the change in the amount of light of a prescribed wavelength is measured by the optical film thickness meter continuously during the film formation, forming a thin film having a desired optical thickness at the prescribed wavelength and deriving the refractive index of the formed thin film at the prescribed wavelength from material constants including the optical thickness and a physical thickness;

   b. conducting test formation of thin films using light of a plurality of wavelengths different from the prescribed wavelength in accordance with same procedures as those described in a. and obtaining refractive indices of the formed films at the plurality of wavelengths;

   c. obtaining an equation expressing a relation between the wavelength and the refractive index of the thin film from the refractive indices of the films at the plurality of wavelengths obtained in the test formation of the thin films and obtaining a refractive index at a desired wavelength different from the examined wavelengths using the equation; and

   d. expressing the amount of light or the change in the amount of light, which is measured continuously during the film formation by the optical film thickness meter, by a theoretical equation containing the refractive index of the thin film for the measurement as a factor, obtaining the amount of light or the change in the amount of light of a desired wavelength continuously during the film formation by substituting the refractive index at the desired wavelength into the theoretical equation; and using the obtained amount of light or the change in the amount of light as the reference amount of light having the desired wavelength.

3. A process according to any one of claims 1 and 2, wherein the refractive index of the desired thin film is derived by using at least a reflectivity of a monitor glass and a transmission spectrum of a filter of the optical film thickness meter, followed by calculation based on the obtained values.

4. A process for producing a lens which comprises a process for forming a thin film described in any one of claims 1, 2 and 3 as a step thereof.

**Patentansprüche**

1. Verfahren zur Ausbildung eines gewünschten Dünnfilms auf einer Oberfläche eines Gegenstandes durch Fliegen und Anlagern lassen eines filmbildenden Materials auf der Oberfläche, welches die folgenden Schritte umfasst: kontinuierliches Messen der Dicke des Dünnfilms durch eine Einrichtung zur Messung der optischen Filmdicke während der Filmbildung und kontinuierliches Steuern der Menge des fliegenden filmbildenden Materials während der Filmbildung auf solche Weise, dass die Menge an Licht, die von der Einrichtung zur Messung der optischen Filmdicke gemessen wird und die die gemessene Filmdicke darstellt, einer Licht-Bezugsmenge, die vorab mittels einer Testbildung des Dünnfilms ermittelt wurde, nahe oder gleich kommt, wobei

   wenn die Testbildung des gewünschten Dünnfilms ausgeführt wird, ein Brechungsindex des gebildeten Dünnfilms jeweils bei einer Vielzahl von Wellenlängen unter Verwendung der Einrichtung zur Messung der optischen Filmdicke abgeleitet wird, eine Licht-Bezugsmenge bei einer Vielzahl von gewünschten Wellenlängen aus den erhaltenen Brechungsindizes durch eine theoretische Berechnung abgeleitet wird und der Dünnfilm mit der gewünschten optischen Dicke bei einer gewünschten Wellenlänge mittels einer erhaltenen Licht-Bezugsmenge gebildet wird, wobei

   A: die Einrichtung zur Messung der optischen Filmdicke eine Einrichtung zur Messung der optischen Dicke ist, die die Abhängigkeit einer Menge von Licht mit einer vorgeschriebenen Wellenlänge, die durch einen Dünnfilm hindurch gelassen oder von einem Dünnfilm reflektiert wird, von mindestens einer Dicke und einem Brechungsindex des Dünnfilms nutzt und die, wenn ein Gegenstand zur Ausbildung eines Films, auf dem ein Dünnfilm ausgebildet wird, mit vorgeschriebenen Licht bestrahlt wird, ein Messergebnis der Dicke des Dünnfilms durch Messen einer Menge an durchgelassenem Licht oder reflektiertem Licht liefert;
   B: eine Menge an durchgelassenem Licht oder reflektiertem Licht oder eine Änderung der Menge an durchgelassenem Licht oder reflektiertem Licht, die sich abhängig von der Dicke eines Dünnfilms, der bereits auf der Oberfläche des Gegenstands zum Ausbilden eines Films ausgebildet ist, ändert, von der Einrichtung zur Messung der optischen Filmdicke während der Filmbildung kontinuierlich gemessen wird; und
   C: die Licht-Bezugsmenge als Datensammlung der Lichtmenge oder der Änderung der Lichtmenge, welche durch die kontinuierlichen Messungen durch die Einrichtung zur Messung der optischen Filmdicke während der Bildung des gewünschten Dünnfilms erhalten wurde, bereitgestellt wird.

2. Verfahren nach Anspruch 1, wobei die Licht-Bezugsmenge entsprechend einem Verfahren erhalten wird, das die folgenden Schritte umfasst:

   a. Durchführung der Testbildung des Dünnfilms, während die Menge des Lichts oder die Änderung der Menge des Lichts mit einer vorgegebenen Wellenlänge von der Einrichtung zur Messung der optischen Filmdicke während der Filmbildung kontinuierlich gemessen wird, Bildung eines Dünnfilms mit einer gewünschten optischen Dicke bei der gewünschten Wellenlänge und Ableitung des Brechungsindex des geformten Dünnfilms bei der gewünschten Wellenlänge aus Materialkonstanten einschließlich der optischen Dicke und der physikalischen Dicke;
   b. Durchführung einer Testbildung des Dünnfilms unter Verwendung einer Vielzahl von Wellenlängen, die sich von der vorgeschriebenen Wellenlänge unterscheiden, entsprechend den gleichen Verfahren, die unter a. beschrieben sind, und Erhalten der Brechungsindices der gebildeten Filme bei der Vielzahl von Wellenlängen;
   c. Erhalten einer Gleichung, die die Beziehung zwischen der Wellenlänge und dem Brechungsindex des Dünnfilms aus den Brechungsindizes der Filme bei der Vielzahl von Wellenlängen, die bei der Testbildung des Dünnfilms erhalten wurden, ausdrückt, und Erhalten eines Brechungsindex bei einer gewünschten Wellenlänge, die sich von den untersuchten Wellenlängen unterscheidet, mittels der Gleichung; und
   d. Ausdrücken der Lichtmenge oder der Änderung der Lichtmenge, die während der Filmbildung von der Einrichtung zur Messung der optischen Filmdicke kontinuierlich gemessen wird, durch eine theoretische Gleichung, die den Brechungsindex des Dünnfilms für die Messung als Faktor enthält, kontinuierliches Erhalten der Menge des Lichts oder der Änderung der Menge des Lichts mit einer bestimmten Wellenlänge während der Filmbildung durch Einsetzen des Brechungsindex bei der gewünschten Wellenlänge in die theoretische Gleichung; und Verwenden der erhaltenen Lichtmenge oder der erhaltenen Lichtmengenänderung als Bezugsmenge für Licht mit der gewünschten Wellenlänge.

3. Verfahren nach einem der Ansprüche 1 und 2, wobei der Brechungsindex des gewünschten Dünnfilms unter Verwendung einer Reflektivität eines Monitorglases und/oder eines Transmissionsspektrums eines Filters der Einrichtung zur Messung der optischen Filmdicke, gefolgt von einer Berechnung aufgrund der erhaltenen Werte, abgeleitet wird.

**4.** Verfahren zur Herstellung einer Linse, welches ein Verfahren zur Bildung eines Dünnfilms nach einem der Ansprüche 1, 2 und 3 als Verfahrensschritt einschließt.

**Revendications**

**1.** Procédé pour la formation d'une couche mince souhaitée sur la surface d'un article en amenant en suspension et en déposant une matière formant couche sur ladite surface, comprenant les étapes consistant à : mesurer en continu une épaisseur de la couche mince au moyen d'un dispositif de mesure d'épaisseur de couche optique pendant la formation de la couche et contrôler en continu une quantité en suspension de la matière formant couche pendant la formation de la couche de manière à ce que la quantité de lumière mesurée par le dispositif de mesure d'épaisseur de couche optique et représentant l'épaisseur de couche mesurée soit proche de ou exactement identique à une quantité de référence de lumière dérivée à l'avance au moyen d'une formation test de la couche mince, dans lequel lorsque ladite formation test de la couche mince souhaitée est réalisée, un indice de réfraction de la couche mince formée est dérivé à une pluralité de longueurs d'onde, respectivement, à l'aide du dispositif de mesure d'épaisseur de couche optique, une quantité de référence de lumière est dérivée à une pluralité de longueurs d'onde souhaitées à partir des indices de réfraction obtenus par calcul théorique et la couche mince ayant une épaisseur optique souhaitée à une longueur d'onde souhaitée est formée à l'aide d'une quantité de référence de lumière obtenue, dans lequel

A : le dispositif de mesure d'épaisseur de couche optique est un dispositif de mesure d'épaisseur optique utilisant la relation entre une quantité de lumière d'une longueur d'onde prescrite transmise via ou réfléchie par une couche mince sur au moins une épaisseur et un indice de réfraction de la couche mince et fournissant un résultat de mesure de l'épaisseur de la couche mince en mesurant une quantité de lumière transmise ou de lumière réfléchie lorsqu'un article pour la formation d'une couche sur lequel une couche mince est formée est irradié avec la lumière prescrite ;
B : une quantité de lumière transmise ou de lumière réfléchie ou une variation de la quantité de lumière transmise ou de lumière réfléchie, qui varie en fonction d'une épaisseur d'une couche mince déjà formée sur la surface de l'article pour la formation d'une couche, est mesurée en continu par le dispositif de mesure d'épaisseur de couche optique pendant la formation de la couche ; et
C : la quantité de référence de lumière est fournie sous la forme de données collectées sur la quantité de lumière ou sur la variation de la quantité de lumière obtenue par la mesure réalisé en continu par le dispositif de mesure d'épaisseur de couche optique pendant la formation de la couche mince souhaitée.

**2.** Procédé selon la revendication 1, dans lequel la quantité de référence de lumière est obtenue selon un procédé comprenant les étapes consistant à :

a. réaliser la formation test de la couche mince tout en mesurant en continu la quantité de lumière ou la variation de la quantité de lumière d'une longueur d'onde prescrite à l'aide du dispositif de mesure d'épaisseur de couche optique pendant la formation de la couche, former la couche mince ayant une épaisseur optique souhaitée à la longueur d'onde prescrite et dériver l'indice de réfraction de la couche mince formée à la longueur d'onde prescrite à partir des constantes de la matière comprenant l'épaisseur optique et une épaisseur physique ;
b. réaliser la formation test de la couche mince à l'aide de la lumière d'une pluralité de longueurs d'onde différentes de la longueur d'onde prescrite selon les mêmes procédures que celles décrites en a. et obtenir les indices de réfraction des couches formées à la pluralité de longueurs d'onde ;
c. obtenir une équation exprimant une relation entre la longueur d'onde et l'indice de réfraction de la couche mince à partir des indices de réfraction des couches à la pluralité de longueurs d'onde obtenus dans la formation test des couches minces et obtenir un indice de réfraction à une longueur d'onde souhaitée différente des longueurs d'onde étudiées à l'aide de l'équation ; et
d. exprimer la quantité de lumière ou la variation de la quantité de lumière, qui est mesurée en continu pendant la formation de la couche par le dispositif de mesure d'épaisseur de couche optique, par l'équation théorique contenant l'indice de réfraction de la couche mince pour la mesure servant de facteur, obtenir en continu la quantité de lumière ou la variation de la quantité de lumière d'une longueur d'onde souhaitée pendant la formation de la couche en remplaçant l'indice de réfraction à la longueur d'onde souhaitée dans l'équation théorique ; et se servir de la quantité de lumière ou de la variation de la quantité de lumière obtenue comme quantité de référence de lumière de la longueur d'onde souhaitée.

**3.** Procédé selon l'une quelconque des revendications 1 et 2, dans lequel l'indice de réfraction de la couche mince souhaitée est dérivé à l'aide d'au moins la réflectivité d'un verre de contrôle et d'un spectre de transmission d'un filtre du dispositif de mesure d'épaisseur de couche optique, puis à l'aide du calcul sur la base des valeurs obtenues.

4. Procédé de production de lentille comprenant un procédé pour la formation d'une couche mince décrit dans l'une quelconque des revendications 1, 2 ou 3 comme une de ses étapes constitutives.

## FIG. 1

ILLUMINATION LIGHT ┊ ↑ REFLECTION LIGHT

DATA OF
AMOUNT
OF LIGHT

OPENING/CLOSING
INSTRUCTION SIGNAL

EVACUATION
UNIT

ON/OFF
SIGNAL

PRESENT
CURRENT
VALUE

EVACUATION
SIGNAL

VACUUM
DEGREE VALUE

CONTROL
CURRENT
VALUE

CONTROL
APPARATUS

SUBSTRATE
TEMPERATURE
VALUE

COMPUTING
APPARATUS

MEANS
FOR INPUT

MEANS FOR STORING DATA OF
REFERENCE AMOUNT OF LIGHT

## FIG. 2

## FIG. 3

# FIG. 4

# FIG. 5

```
        ( START OF DESIGNING )
                    │
    ┌───────────────▼───────────────┐
    │  ┌─────────────────────────────────┐
    │  │   EXTENSION AMOUNT FOR SPECIFIC  │
    │  │  FILTER (WAVELENGTH) IS OBTAINED │
    │  │     BY TEST FORMATION OF FILM    │
    │  └─────────────────────────────────┘
    │                │
    │  ┌─────────────────────────────────┐
    │  │  REFRACTIVE INDEX CORRESPONDING  │
    │  │  TO EXTENSION AMOUNT IS OBTAINED │
    │  │     BY THEORETICAL CALCULATION   │
    └──└─────────────────────────────────┘
                    │
    ┌───────────────────────────────────┐
    │     COEFFICIENTS OF APPROXIMATE    │
    │  EQUATION IS OBTAINED FROM PLURALITY│
    │    OF DATA OF REFRACTIVE INDICES   │
    └───────────────────────────────────┘
                    │
   ┌─────────────────────────────────────┐
   │ REFRACTIVE INDEX AT DESIRED WAVELENGTH│
   │ IS CALCULATED USING APPROXIMATE EQUATION│
   └─────────────────────────────────────┘
                    │
    ┌───────────────────────────────────┐
    │   DATA OF REFERENCE AMOUNTS OF LIGHT│
    │    AT DESIRED WAVELENGTH IS PREPARED│
    └───────────────────────────────────┘
                    │
            ( FILM FORMATION )
```

# FIG. 6

| CENTRAL WAVELENGTH OF FILTER (nm) | EXTENSION AMOUNT (%) | REFRACTIVE INDEX |
|---|---|---|
| 396 | 54.44 | 2.2493 |
| 417 | 54.66 | 2.2473 |
| 429 | 52.39 | 2.2150 |
| 453 | 50.60 | 2.1873 |
| 486 | 50.35 | 2.1774 |
| 500 | 49.46 | 2.1635 |
| 543 | 48.60 | 2.1450 |
| 544 | 48.78 | 2.1472 |
| 551 | 48.66 | 2.1444 |
| 571 | 48.50 | 2.1392 |
| 588 | 47.52 | 2.1243 |
| 599 | 47.10 | 2.1175 |
| 599 | 47.15 | 2.1181 |
| 599 | 47.16 | 2.1182 |
| 599 | 47.75 | 2.1253 |

## OBSERVED VALUE

*FIG. 7*

## APPROXIMATED EQUATION

VARIATION OF ACTUAL AMOUNT OF LIGHT

*FIG. 8*

VARIATION OF REFERENCE AMOUNT OF LIGHT